# EUROPEAN PATENT SPECIFICATION

(11) **EP 1 402 649 B1**
(45) Date of publication and mention of the grant of the patent: **31.10.2007**
(21) Application number: 01950101.4
(22) Date of filing: 04.07.2001
(51) Int. Cl.: H03M 13/29, H04L 1/00

(54) **ITERATION METHOD FOR OBTAINING A FINAL QUALITY-IMPROVED RECEPTION SIGNAL**
ITERATIONSVERFAHREN ZUM ERZIELEN EINES FINALEN EMPFANGSSIGNALS MIT HÖHERER QUALITÄT
PROCEDE D'ITERATION POUR OBTENIR UN SIGNAL DE RECEPTION FINAL DE MEILLEURE QUALITE

(43) Date of publication of application: 31.03.2004
(73) Proprietor: TELEFONAKTIEBOLAGET LM ERICSSON (publ), 164 83 Stockholm (SE)
(72) Inventor: BOLT, Jaap, NL-7559 CS Hengelo (NL); BOERRIGTER, Mark, NL-7572 TW Oldenzaal (NL)
(74) Representative: Prins, Adrianus Willem
(86) International application number: PCT/NL2001/000502
(87) International publication number: WO 2003/005590

(56) References cited:
- EP-A- 1 009 098
- EP-A- 1 079 529
- US-B1- 6 192 503

## Description

The invention is related to a method for processing of a reception signal in a communication system to obtain a final quality-improved reception signal of a quality which exceeds a predetermined minimum quality, wherein the processing of the reception signal comprises a number of iterative processing steps, wherein each processing step improves the quality of the reception signal, wherein after each subsequent processing step a processed signal is obtained.

The invention is further related to an apparatus for a communication system, comprising a processor which is arranged to process a reception signal to obtain a final quality-improved reception signal of a quality which exceeds a predetermined minimum quality, wherein the processing of the reception signal comprises a number of iterative processing steps, wherein each processing step improves the quality of the reception signal, wherein after each subsequent processing step a processed signal is obtained.

Such a method is known *per sé* and is applied in known communication systems in which the quality of a reception signal as received may be relatively poor. By such methods the quality of the reception signal is improved by each subsequent processing step. In the known method the number of iterative processing steps is predetermined. This number is set high enough to ensure that the final quality-improved reception signal is formed even out of reception signals of a relatively poor quality. The quality of the reception signal as received may vary substantially. For instance, in mobile cell based communication systems a reception station may receive a relatively high quality reception signal if the transmission between the sender station and the reception station is relatively direct and the distance between the sender station and the reception station is relatively short. However, a reception signal of a relatively poor quality may be received if the transmission is disturbed by the presence of for instance buildings which provide bad signal propagation conditions or if the transmission takes place over a long distance. Reflections, interference, and weather related phenomena may also occur and result in a reception signal of a relatively poor quality. As the communication systems have improved in terms of the possibilities of receiving even the weakest signals, and the predetermined minimum quality in a communication system has remained constant if not increased, the number of predetermined iterative processing steps to be carried out by the known method is known to be high.

A disadvantage of the known method is that also in the case of receiving a reception signal of a relatively high quality, the predetermined number of iterative processing steps is carried out despite the fact that after a relatively low number of iterative processing steps the processed signal will be of a quality which exceeds the predetermined minimum quality. By carrying out the predetermined number of iterative processing steps in the case of receiving a relatively high quality reception signal, the delay by processing is unnecessarily long and at least a part of the energy used for the processing is unnecessarily wasted. In addition to this, it is important to note that in communication systems comprising a processor, which is arranged to process various reception signals at a given time according to the known method, the average number of iterative processing steps which is carried out to obtain a final quality-improved reception signal, is equal to the predetermined number of iterative processing steps. In practice, the iterative processing steps are in the communication system carried out by a processor which comprises a relatively small volume of the communication system. By carrying out the iterative processing steps, heat is generated in the processor. As the average number of iterative processing steps carried out is relatively high, relatively much heat is generated. The design of the processor and/or the communication system needs to be such the processor is cooled sufficiently when processing of the reception signals takes place. Implementation of cooling devices, which can adequately deal with the generated heat, leads to high costs of the design and fabrication of these communication systems.

Documents EP-A-1 079 529 and EP-A-1 009 098 show Turbo decoders.

The object of the invention is to provide a method which ensures the reception signal to be processed to obtain a final quality-improved reception signal of a quality which exceeds a predetermined minimum quality, without unnecessarily carrying out the predetermined number of iterative processing steps.

The object is achieved by a method according to the invention which is characterised in that the method further comprises at least one monitoring step in which the quality of the processed signal is monitored, wherein after each monitoring step the processing is continued if the monitored quality does not exceed the predetermined minimum quality and wherein the processing is stopped if the monitored quality exceeds the predetermined minimum quality so that the processed signal forms the final quality-improved reception signal and wherein the predetermined minimum quality can be set by a user.

This has the advantage that the predetermined number of iterative processing steps is not carried out unnecessarily. In comparison with the known method, the average delay time due to processing the reception signal to obtain a final quality-improved reception signal, is cut down and the average amount of energy spent on processing the reception signal is reduced.

Furthermore, as the predetermined number of iterative steps is not carried out unnecessarily, the average number of iterative steps, which is carried out to obtain a final quality-improved reception signal will, considered from a statistical point of view, be relatively low as compared to the predetermined number of iterative processing steps. Consequently, a processor which is arranged to process various reception signals at a given time, will, as a result of the relatively low average number of iterative steps carried out per reception signal to obtain a final quality-improved reception signal, generate relatively little heat. This offers opportunities for cutting down in costs which are related to cooling the processor and/or communication system. Alternatively, the number of reception signals a processor can process at a given time may be increased without having to improve the cooling devices.

A preferred embodiment of a method according to the invention is characterised in that the monitoring step takes place after each set of a predetermined number of subsequent iterative processing steps. This has the advantage that the method offers more opportunities to avoid unnecessarily carrying out processing steps. Consequently, the method offers more opportunities to cut down the average delay time in the communication system and to reduce the average amount of energy spent on processing of the reception signal. Additionally, the average number of iterative steps carried out per reception signal which is processed by a processor to obtain a final quality-improved signal of a quality which exceeds a predetermined minimum quality, will be relatively low. As a result, the design and fabrication costs of the processor may be reduced and/or more reception signals can be dealt with at a given time.

The apparatus according to the invention is characterised in that the apparatus further comprises a monitor which is arranged to carry out at least one monitoring step in which the quality of the processed signal is monitored, wherein the apparatus is further arranged to continue the processing if the monitored quality does not exceed the predetermined minimum quality and wherein the apparatus is arranged to stop the processing if the monitored quality exceeds the predetermined minimum quality so that the processed signal forms the final quality-improved reception signal and wherein the predetermined minimum quality can be set by a user.

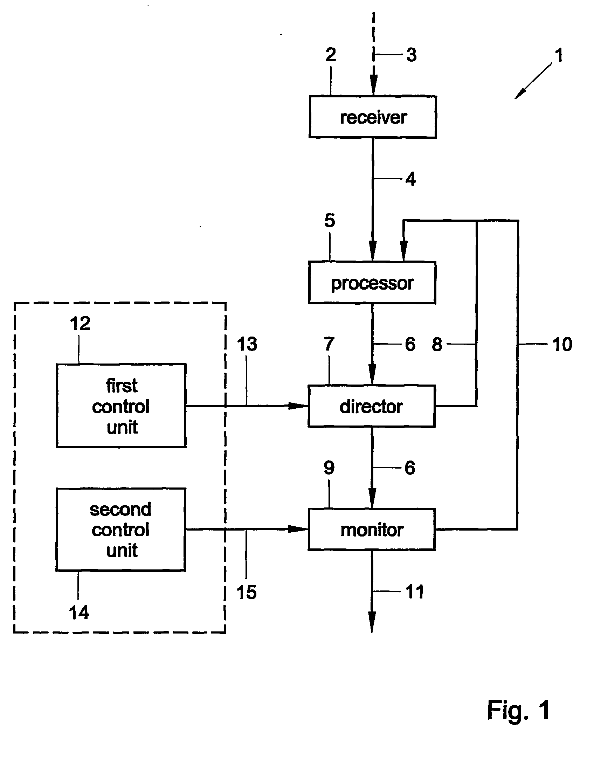

These and other aspects of the invention will be apparent from the embodiment described hereafter in conjunction with the accompanying drawing.

The drawing shows schematically an apparatus 1 which is arranged to carry out a method according to the invention. The apparatus 1 comprises a wireless receiver 2 which is arranged to receive a reception signal 3. The received reception signal 4 is processed by a processor 5 to obtain a processed signal 6 with a quality which is improved with respect to the quality of the received reception signal 4. The processed signal 6 is by a director 7 as a redirected signal 8 directed back into the processor 5 to further improve the quality of the processed signal 6. Directing a processed signal 6 as a redirected signal 8 back into the processor 5 and processing the redirected signal 8 to obtain a processed signal 6 of a quality which is improved with respect to the redirected signal 8, forms an iterative processing step. After each subsequent iterative processing step a processed signal 6 is obtained. After a predetermined number of such subsequent iterative processing steps, the director 7 directs the processed signal 6 to a monitor 9 which is arranged to carry out a monitoring step in which the quality of the processed signal 6 is monitored. After each monitoring step the processed signal 6 is as a return signal 10 returned to the processor 5 to again be processed if the quality of the processed signal 6 as monitored by the monitor 9 does not exceed a predetermined minimum quality. Also returning a processed signal 6 as a return signal 10 to the processor and processing the return signal 10 to obtain a processed signal 6 of a quality which is improved with respect to the returned signal 10, forms an iterative processing step. Alternatively, the processed signal 6 forms after a monitoring step a final quality-improved reception signal 11 if the quality of the processed signal 6 as monitored by the monitor 9 exceeds a predetermined minimum quality. In that case the processing of the processed signal 6 is stopped.

In a special embodiment of the invention the apparatus 1 may be arranged such that the monitoring step 6 only take place after each set of a predetermined number of subsequent iterative processing steps. The number of subsequent iterative steps is in that case counted by the director 7 and compared with the predetermined number of subsequent iterative processing steps. If the number of subsequent iterative processing steps as counted by the director 7 equals the predetermined number of subsequent iterative processing steps, the processed signal 6 is directed to the monitor 9. The predetermined number of subsequent iterative processing steps in a set may even be pre-set to decrease for each subsequent set of iterative processing steps. This may be efficient as the probability of obtaining a processed signal 6 of a quality which exceeds a predetermined minimum quality, increases with the total number of iterative processing steps carried out. The director 7 may be controlled by a first control-unit 12. Predetermined numbers can be pre-set in the first control-unit 12 and as control-input 13 be directed to the director 7.

The director 7 may also be arranged to direct each processed signal 6 to the monitor 9. In that case the predetermined number of processing steps in each set equals one. The apparatus 1 may in this case not comprise control-unit 13. If the apparatus 1 is arranged to carry out a method according to the invention in which the quality of each processed signal 6 is monitored, the apparatus may not even comprise the director 7.

In a preferred embodiment the processing comprises the well-known turbo decoding method. The processed signal 6 may then comprise an output data block. The predetermined minimum quality may in that case comprises a maximum number of faults in the output data block. For an optimum final quality-improved reception signal 11, the maximum number of faults in the output data block may be set equal to zero.

The apparatus 1 may be arranged such that a user can set the predetermined minimum quality, for instance, in terms of a maximum number of faults in an output data block. For this reason the apparatus 1 may, as shown in the drawing, comprise a second control-unit 14. The predetermined minimum quality can be pre-set in the second control-unit 14 and as quality control input 15 be directed to the monitor 9. The monitor 9 can use the quality control input 15 to compare the quality of the processed signal 6 as monitored, with the predetermined minimum quality. If the quality of the processed signal 6 as monitored does not exceed the predetermined minimum quality, the processed signal 6 is returned as a return signal 10 to the processor 5 for further processing. If the quality of the processed signal 6 as monitored exceeds the predetermined minimum quality, the processed signal 6 forms a final quality-improved reception signal 11. The monitor 9 may be arranged to carry out a monitoring step according to the known CRC mechanism. The apparatus 1 may not comprise the second control-unit 14 as the apparatus 1 may only be intended to carry out a method in which one predetermined minimum quality is used. This one predetermined minimum quality may then be pre-set in the monitor 9. In cases where the apparatus comprises the first control-unit 12 and the second control-unit 14, these control-units 12,14 may be incorporated into one control-unit. The apparatus 1 may further be arranged to employ various techniques such as frequency division multiplexing, time division multiplexing an/or code division multiplexing. In the case of frequency division multiplexing the receiver 2 will be arranged to receive a plurality of reception signals 3 with each a mutually different frequency. The processing power saved by a method according to the invention becomes in such an apparatus 1 available, for instance, for employing extra channels in the communication system. Without necessarily having to expand on battery power and/or processing hardware. In the case of use of time division multiplexing and/or code division multiplexing the above mentioned advantages related to expansion in the number of signals to be dealt with by a processor and/or related to reduction of design and fabrication costs of the processor equally apply. In an apparatus 1 according to the invention it is also possible to save on parallel hardware and/or the clocking speed as used in such an apparatus. The predetermined minimum quality can for instance be set lower, using control-unit 14, in cases where saving battery power is more important than the quality of the reception signals. This may for instance be of interest for mobile systems which are used in the desert, where the user will, whilst listening to the final quality-improved reception signal, not be disturbed by noises in the immediate surroundings. Although in this example a wireless receiver is shown, the invention is not limited to the processing of wireless reception signals. The apparatus can also process reception signals 2 in communication systems wherein the reception signals 2 are received via a wire or any other medium transmitting signal to a reception station 2.

Application of the apparatus and method according to the invention is particularly useful in a communication system which employs a turbo decoder for processing reception signals. Signals obtained from reading a CD-rom as well as signals obtained from satellite communication systems may, for instance, also be processed by a method according to the invention.

Although an embodiment of the present invention has been described in detail herein, it is to be understood that this invention is not limited to this precise embodiment and that modifications and variations may be effected therein by one skilled in the art without departing from the scope of the invention as defined by the appended claims.

## Claims

1. Method for processing a reception signal in a communication system to obtain a final quality-improved reception signal of a quality which exceeds a predetermined minimum quality, wherein the processing of the reception signal comprises a number of iterative processing steps, wherein each processing step improves the quality of the reception signal, wherein after each subsequent processing step a processed signal is obtained, wherein the method further comprises at least one monitoring step in which the quality of the processed signal is monitored, wherein after each monitoring step the processing is continued if the monitored quality does not exceed the predetermined minimum quality and wherein the processing is stopped if the monitored quality exceeds the predetermined minimum quality so that the processed signal forms the final quality-improved reception signal, **characterised in that** the predetermined minimum quality can be set by a user.

2. Method according to claim 1, **characterised in that**, the monitoring step takes place after each set of a predetermined number of subsequent iterative processing steps.

3. Method according to claim 2, **characterised in that**, the predetermined number of processing steps equals one.

4. Method according to any one of the previous claims, **characterised in that** the processing comprises turbo decoding.

5. Method according to claim 4, **characterised in that**, the processed reception signal comprises an output data block.

6. Method according to claim 5, **characterised in that**, the predetermined minimum quality comprises a maximum number of faults in the output data block.

7. Method according to claim 6, **characterised in that**, the maximum number of faults in the output data block equals zero.

8. Apparatus for a communication systems (1), comprising a processor (5) which is arranged to process a reception signal to obtain a final quality improved reception signal of a quality which exceeds a predetermined minimum quality, wherein the processing of the reception signal comprises a number of iterative processing steps, wherein each processing step improves the quality of the reception signal, wherein after each subsequent processing step a processed signal is obtained, the apparatus further comprises a monitor (9) which is arranged to carry out at least one monitoring step in which the quality of the processed signal is monitored, wherein the apparatus is further arranged to continue the processing if the monitored quality does not exceed the predetermined minimum quality and wherein the apparatus is arranged to stop the processing if the monitored quality exceeds the predetermined minimum quality so that the processed signal forms the final quality-improved reception signal, **characterised in that** the apparatus is further arranged that a user can set the predetermined minimum quality.

9. Apparatus according to claim 8, **characterised in that**, the processor (5) is arranged to employ a turbo decoding method.

10. Apparatus according to claim 9, **characterised in that**, the processed reception signal comprises an output data block.

11. Apparatus according to claim 10, **characterised in that**, the predetermined minimum quality comprises a maximum number of faults in the output data block.

12. Apparatus according to claim 11, **characterised in that**, the maximum number of faults in the output data block equals zero.

13. Wireless reception station for a communication system comprising an apparatus according to any one of the claims 8-12.

## Patentansprüche

1. Verfahren zum Verarbeiten eines Empfangssignals in einem Kommunikationssystem zum Erhalten eines qualitätsverbesserten End-Empfangssignal mit einer Qualität, die eine vorbestimmte Mindestqualität übersteigt, wobei das Verarbeiten des Empfangssignals eine Anzahl von iterativen Verarbeitungsschritten umfasst, wobei bei jedem Verarbeitungsschritt die Qualität des Empfangssignals verbessert wird, wobei nach jedem nachfolgenden Verarbeitungsschritt ein Verarbeitungssignal erhalten wird, wobei das Verfahren ferner mindestens einen Überwachungsschritt umfasst, bei dem die Qualität des Verarbeitungssignals überwacht wird, wobei nach jedem Überwachungsschritt die Verarbeitung fortgesetzt wird, wenn die überwachte Qualität nicht die vorbestimmte Mindestqualität übersteigt, und wobei die Verarbeitung gestoppt wird, wenn die überwachte Qualität die vorbestimmte Mindestqualität übersteigt, so dass das Verarbeitungssignal das qualitätsverbesserte End-Empfangssignal bildet,
**dadurch gekennzeichnet, dass**
die vorbestimmte Mindestqualität von einem Benutzer festgelegt werden kann.

2. Verfahren nach Anspruch 1, **dadurch gekennzeichnet, dass** der Überwachungsschritt nach jedem Satz einer vorbestimmten Anzahl von aufeinanderfolgenden Verarbeitungsschritten erfolgt.

3. Verfahren nach Anspruch 2, **dadurch gekennzeichnet, dass** die vorbestimmte Anzahl von Verarbeitungsschritten gleich Eins ist.

4. Verfahren nach einem der vorhergehenden Ansprüche, **dadurch gekennzeichnet, dass** die Verarbeitung eine Turbodekodierung umfasst.

5. Verfahren nach Anspruch 4, **dadurch gekennzeichnet, dass** das verarbeitete Empfangssignal einen Ausgangsdatenblock aufweist.

6. Verfahren nach Anspruch 5, **dadurch gekennzeichnet, dass** die vorbestimmte Mindestqualität eine maximale Anzahl von Fehlern in dem Ausgangsdatenblock aufweist.

7. Verfahren nach Anspruch 6, **dadurch gekennzeichnet, dass** die maximale Anzahl von Fehlern in dem Ausgangsdatenblock gleich Null ist.

8. Vorrichtung für ein Kommunikationssystem (1) mit einem Prozessor (5), der zum Verarbeiten eines Empfangssignals zwecks Erhalts eines qualitätsverbesserten End-Empfangssignal mit einer Qualität vorgesehen ist, die eine vorbestimmte Mindestqualität übersteigt, wobei das Verarbeiten des Empfangssignals eine Anzahl von iterativen Verarbeitungsschritten umfasst, wobei bei jedem Verarbeitungsschritt die Qualität des Empfangssignals verbessert wird, wobei nach jedem nachfolgenden Verarbeitungsschritt ein Verarbeitungssignal erhalten wird, wobei die Vorrichtung ferner einen Monitor (9) aufweist, der zum Durchführen mindestens eines Überwachungsschritts vorgesehen ist, bei dem die Qualität des Verarbeitungssignals überwacht wird, wobei die Vorrichtung ferner dazu vorgesehen ist, die Verarbeitung fortzusetzen, wenn die überwachte Qualität nicht die vorbestimmte Mindestqualität übersteigt, und wobei die Vorrichtung dazu vorgesehen ist, die Verarbeitung zu stoppen, wenn die überwachte Qualität die vorbestimmte Mindestqualität übersteigt, so dass das Verarbeitungssignal das qualitätsverbesserte End-Empfangssignal bildet,
**dadurch gekennzeichnet, dass**
bei der Vorrichtung die vorbestimmte Mindestqualität von einem Benutzer festgelegt werden kann.

9. Vorrichtung nach Anspruch 8, **dadurch gekennzeichnet, dass** der Prozessor (5) dazu vorgesehen ist, ein Turbodekodierverfahren durchzuführen.

10. Vorrichtung nach Anspruch 9, **dadurch gekennzeichnet, dass** das verarbeitete Empfangssignal einen Ausgangsdatenblock aufweist.

11. Vorrichtung nach Anspruch 10, **dadurch gekennzeichnet, dass** die vorbestimmte Mindestqualität eine maximale Anzahl von Fehlern in dem Ausgangsdatenblock aufweist.

12. Vorrichtung nach Anspruch 11, **dadurch gekennzeichnet, dass** die maximale Anzahl von Fehlern in dem Ausgangsdatenblock gleich Null ist.

13. Drahtlose Empfangsstation für ein Kommunikationssystem mit einer Vorrichtung nach einem der Ansprüche 8-12.

## Revendications

1. Procédé de traitement d'un signal de réception dans un système de communication afin d'obtenir un signal de réception à qualité finale améliorée présentant une qualité qui dépasse une qualité minimale prédéterminée, où le traitement du signal de réception comprend un certain nombre d'étapes itératives de traitement, où chaque étape de traitement améliore la qualité du signal de réception, où, après chaque étape de traitement successive, un signal traité est obtenu, où le procédé comprend en outre au moins une étape de surveillance, où la qualité du signal traité est surveillée, où après chaque étape de surveillance, le traitement est poursuivi si la qualité surveillée ne dépasse pas la qualité minimale prédéterminée, et où le traitement est arrêté si la qualité surveillée dépasse la qualité minimale prédéterminée de sorte que le signal traité forme le signal de réception à qualité finale améliorée, **caractérisé en ce que** la qualité minimale prédéterminée peut être établie par un utilisateur.

2. Procédé selon la revendication 1, **caractérisé en ce que** l'étape de surveillance a lieu après chaque ensemble constitué d'un nombre prédéterminé d'étapes itératives de traitement successives.

3. Procédé selon la revendication 2, **caractérisé en ce que** le nombre prédéterminé d'étapes de traitement est égal à un.

4. Procédé selon l'une quelconque des revendications précédentes, **caractérisé en ce que** le traitement comprend un turbodécodage.

5. Procédé selon la revendication 4, **caractérisé en ce que** le signal de réception traité comprend un bloc de données de sortie.

6. Procédé selon la revendication 5, **caractérisé en ce que** la qualité minimale prédéterminée comprend un nombre maximum de défauts dans le bloc de données de sortie.

7. Procédé selon la revendication 6, **caractérisé en ce que** le nombre maximal de défauts dans le bloc de données de sortie est égal à zéro.

8. Dispositif destiné à un système de communication (1), comprenant un dispositif de traitement (5) qui est conçu pour traiter un signal de réception afin d'obtenir un signal de réception à qualité finale améliorée présentant une qualité qui dépasse une qualité minimale prédéterminée, où le traitement du signal de réception comprend un certain nombre d'étapes itératives de traitement, où chaque étape de traitement améliore la qualité du signal de réception, où après chaque étape de traitement successive, un signal traité est obtenu, le dispositif comprend en outre un moniteur (9) qui est conçu pour exécuter au moins une étape de surveillance, où la qualité du signal traité est surveillée, où le dispositif est en outre conçu pour poursuivre le traitement si la qualité surveillée ne dépasse pas la qualité minimale prédéterminée et où le dispositif est conçu pour arrêter le traitement si la qualité surveillée dépasse la qualité minimale prédéterminée de sorte que le signal traité forme le signal de réception à qualité finale améliorée, **caractérisé en ce que** le dispositif est en outre conçu de sorte qu'un utilisateur puisse établir la qualité minimale prédéterminée.

9. Dispositif selon la revendication 8, **caractérisé en ce que** le dispositif de traitement (5) est conçu pour employer un procédé de turbodécodage.

10. Dispositif selon la revendication 9, **caractérisé en ce que** le signal de réception traité comprend un bloc de données de sortie.

11. Dispositif selon la revendication 10, **caractérisé en ce que** la qualité minimale prédéterminée comprend un nombre maximal de défauts dans le bloc de données de sortie.

12. Dispositif selon la revendication 11, **caractérisé en ce que** le nombre maximal de défauts dans le bloc de données de sortie est égal à zéro.

13. Station de réception sans fil pour un système de communication comprenant un dispositif selon l'une quelconque des revendications 8 à 12.
